# EUROPEAN PATENT SPECIFICATION

(11) **EP 2 761 318 B1**
(45) Date of publication and mention of the grant of the patent: **17.06.2015**
(21) Application number: 11815738.7
(22) Date of filing: 27.12.2011
(51) Int. Cl.: G01R 33/14, G01R 33/12, H01F 29/08

(54) **DEVICE AND TESTING PROCEDURE FOR DETERMINATION OF MAGNETIC CIRCUIT QUALITY**
VORRICHTUNG UND TESTVERFAHREN ZUR BESTIMMUNG DER QUALITÄT EINER MAGNETSCHALTUNG
DISPOSITIF ET PROCÉDURE DE TEST POUR DÉTERMINER LA QUALITÉ D'UN CIRCUIT MAGNÉTIQUE

(30) Priority: 28.09.2011 SI 201100387
(43) Date of publication of application: 06.08.2014
(73) Proprietor: Univerza V Mariboru, 2000 Maribor (SI)
(72) Inventor: DOLINAR, Drago, 2000 Maribor (SI); PETRUN, Martin, 2364 Ribnica na Pohorju (SI); KLOPCIC, Beno, 1231 Crnuce (SI)
(74) Representative: Marn, Jure
(86) International application number: PCT/SI2011/000079
(87) International publication number: WO 2013/048348

(56) References cited:
- JP-A- 8 122 387
- US-A1- 2007 285 195

## Description

### FIELD OF THE INVENTION

### Electrical engineering; measurings; transformers; transformer cores

### TECHNICAL PROBLEMS

Technical problem solved by this invention is elimination of otherwise time-consuming process of transformer iron core non-linear characteristics evaluation, further reduction of otherwise time-consuming and demanding demagnetization of iron cores before testing, further elimination of otherwise time-consuming quality check of manufactured transfomer cores, further elimination of otherwise time-consuming individual check of transformer cores, further the complexity of comparison of transformer iron cores of different manufacturers, different series, different dimensions and/or different constructions, further the quick measuring procedure, further simplicity of the measuring, furthter the universality of measurings, further time-consuming quality check of the transformer iron core air gap.

### STATE OF THE ART

The exsisting methods and mesuring instruments used by transformer core manufacturers are different and are usually based on one of the standards listed below:
**IEC 60404-2 ed3.1 Consol. with am1 (2008-06)** Magnetic materials - Part 2: Methods of measurement of the magnetic properties of electrical steel strip and sheet by means of an Epstein frame.
**IEC 60404-3 ed2.2 Consol. with am1&2 (2010-04)** Magnetic materials - Part 3: Methods of measurement of the magnetic properties of electrical steel strip and sheet by means of a single sheet tester.
**IEC 60404-4 ed2.2 Consol. with am1**&**2 (2008-11)** Magnetic materials - Part 4: Methods of measurement of D.C. magnetic properties of magnetically soft materials.
**IEC 60404-6 ed2.0 (2003-06)** Magnetic materials - Part 6: Methods of measurement of the magnetic properties of magnetically soft metallic and powder materials at frequencies in the range 20 Hz to 200 kHz by the use of ring specimens.
**IEC 60404-10 ed1.0 (1988-08)** Magnetic materials. Part 10: Methods of measurement of magnetic properties of magnetic sheet and strip at medium frequencies.
**IEC 60740-1 ed1.0 (2005-08)** Laminations for transformers and inductors - Part 1: Mechanical and electrical characteristics.
**IEC 62044-1 ed1.0 (2002-05)** Cores made of soft magnetic materials - Measuring methods - Part 1: Generic specification.
**IEC 62044-2 ed1.0 (2005-03)** Cores made of soft magnetic materials - Measuring methods - Part 2: Magnetic properties at low excitation level.
**IEC 62044-3 ed1.0 (2000-12)** Cores made of soft magnetic materials - Measuring methods - Part 3: Magnetic properties at high excitation level.
   IEEE-Std 393-1991
   ASTM A772 A772M-00 (2005)
   and US 2007/285195 A1.

There is a long list of standards, therefore, transformer core manufacturers can use various measuring methods, i.e. they apply sinusoidal voltage supply of certain frequency (i.e. 400 Hz), determine the maximum magnetic field density and measure active power P and apparent power S at the rated point (IEC 404-2). The sinusoidal change of the magnetic flux desity B inside the tested iron core must be ensured during such testing, which requires a special testing equipment. They can also use sinusoidal current excitation and measure induced voltage in the secondary winding (ASTM A772 A772M-00 (2005)). This method requires sinusoidal magneto motive force (mmf) in the tested core.

There are a lot of measuring devices on the market to determine the magnetic properties, such as BROCKHAUS MESSTECHNIK (C 510, MPG 100D, EBA), MAGNET-PHYSIK DR. STEINGROEVER GmbH (Remagraph C-500), e.t.c. These devices are based on previously mentioned standards and are used to determine the magnetic properties and to ensure quality in overall process of transformer core manufacturing.

Disadvantages of the measuring methods and devices based on the standards listed above are:
- previously demagnetization of cores is necessary,
- time-consuming process,
- expensive measuring equipment, and
- difficult comparison of the cores with different cross-sections area and lamination thicknesses.

Disadvantages of the measuring procedures are emphasized due to the large number of standards, which can be used when checking the transformer core quality. In such way, it is difficult for a buyer of iron cores to compare cores of different manufactures. The transformer cores are often not tested at the rated point in which the iron core operates in the final product. Also, the tests are mostly based on sinusoidal excitation, however, majority of transformers is already supplied by inverters, which give a pulse form of output voltage. Due to such difficulties, the buyer must provide his/her own testing equipment for comparison of different cores that can be very expensive.

### DETAILED DESCRIPTION OF THE INVENTION

The above mentioned technical problem is solved by **Device and testing procedure for determining magnetic circuit cores quality,** which is equiped with a hysteresis current controller on the primary side of the transformer in no-load (open secondary winding). Device or invention is for the patent application purposes reffered to as »**Transformer Iron Core Tester**«. Device that determines the quality of magnetic circuits comprises a pulse excitation and hysteresis control of the transformer primary current. The invention subject, i.e. **Transformer Iron Core Tester,** switches the supply voltage by the H-bridge inverter with the help of the hysteresis controller when the primary current reaches the defined maximum value, priority 4A. The **Transformer Iron Core Tester** evaluates the iron core quality and the magnetic characteristic of analyzed magnetic circuit on the basis of determined operating frequency *f*, core cross-section area *A*_{Fe} as well as the measured reactive power *Q*. As lower is the product of cross-section area and frequency *A*_{Fe}**f*, as well as the reactive power *Q* is, the better is the quality of the core.

The invention is further described by means of drawingsrepresenting an integral part of this patent application as follows:

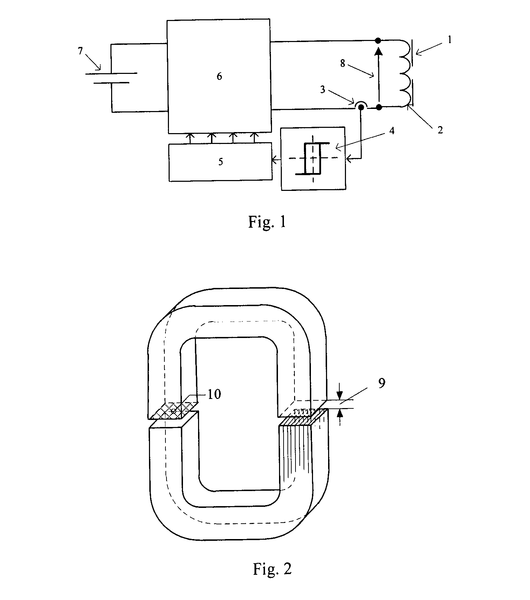

Figure 1 presents circuit drawing of transformer iron core tester core (1), transformer primary winding (2), primary current sensor (3), hysteresis current controller (4), control logic for H-bridge inverter switching (5), H-bridge inverter (6), DC bus (7) and primary voltage sensor (8).
Figure 2 presents transformer iron core with an air gap (9) and cross-section area *A*_{Fe} (10).

**Transformer Iron Core Tester** is carried out by means of a regular H-bridge inverter (6) which does not require any expensive measuring equipment. The operation point in tested iron core is defined with the maximum magneto motive force (mmf) *N*ₚ**I*ₘₐₓ, which is determined by the number of turns *N*_{P} of primary winding (2) and current *I*ₘₐₓ, controlled by the hysteresis current controller (4). The primary current is measured by primary current sensor (3) while H-bridge inverter (6) is switched by the hysterysis current controller (4) using corresponding control logic (5). The quality of tested core (1) is defined with the maximum flux density *B*ₘₐₓ, which is reached at maximum mmf, as well as with the input reactive power *Q*, which value should be as low as possible. The value of input reactive power *Q* mostly depends on the size of the transformer air gap (9). The value of flux density *Bₘₐₓ* and the input reactive power *Q* can be calculated from the measured primary current (sensor (3)) and primary voltage (sensor (8)). For particular examples, where voltage of DC bus (7) and transformer core cross-section area *A*_{Fe} (10) are constant, the lower operation frequency *f* means the higher quality of the tested transformer iron core. The before mentioned criterion of lower frequency *f* is replaced by the criterion of a lower product *A*_{Fe}**f*, when iron cores with different cross-section areas *A*_{Fe} are compared. Voltage *U*_{DC} of D.C. bus is constant. Iron cores with the different cross-section areas *A*_{Fe} can be compared in that way. The transformer iron core tester, respectively the procedure of core quality evaluation, is preferentially adequate for input quality checking of iron cores before the asembling of transformers.

The **Transformer Iron Core Tester** frequency range can be adequately set by changing *N*ₚ and *U*_{DC}, in a way that there is no impact of eddy currents on the magnetic characteristic. Due to this the cores with differet lamination thicknesses can be also compared. In order to test transformer iron cores it is not previously necessary to demagnetize the tested iron cores. Already built-in cores can be also checked during the process of asembling. Determination of iron core quality is illustrated with the comparison of three core samples with the following measurement results:

| Core | *A*_{Fe}**f* [mm²/s] | *Q* [Var] |
|---|---|---|
| 1 | 56142 | 15.07 |
| 2 | 56570 | 10.52 |
| 3 | 68429 | 14.79 |

The first core is of better quality than the third core. The value of product *A*_{Fe}**f* is considerably lower which shows that the value *B*ₘₐₓ of the first core is much higher than of the third core. The comparison of the first and second core shows that they riches an approximatelly equal *B*ₘₐₓ, although the air gap in the second core is treated much better in relation to the first core, hence the value of reaction power *Q* is lower. Therefore, the second core is the best choice among the three cores.

## Claims

1. Device for determining the quality of a magnetic circuit (1), said device comprising means for pulse excitation and a hysteresis controller (4) for controlling a current in a transformer primary winding (2), said device being configured such that the hysteresis controller (4) switches a source voltage when the current in the primary winding (2) reaches a chosen maximum value Iₘₐₓ, **characterized in that** said device is configured to evaluate a magnetic characteristic of the magnetic circuit on the basis of a frequency of a system operation, a core cross-section A_{Fe} (10) of an iron core and a calculated reactive power.

2. Device according to the previos claim **characterized in that** it comprises a primary current sensor (3), a control logic for inverter switching (5), an inverter (6), a DC bus and a primary voltage sensor (8).

3. Method of testing a magnetic circuit, the method comprising the step of determining the quality of the magnetic circuit by use of the device according to any of the previous claims, **characterized in that** the step of determining the quality comprises estimating the quality of the magnetic circuit such a decreasing product of the core cross-section area A_{Fe} with a frequency f, A_{Fe}*f, and a lower reactive power Q means a better core quality.

4. Method according to Claim 3 **characterized in that** the measurement lasts one or more periods.

5. Method according to any of Claims 3 or 4 **characterized in that** the properties of an air gap surface (10) of a transformer iron core and other properties, such as properties of core damages, are determined.

6. Method according to any of Claims 3 to 5 **characterized in that** in case when the voltage of the DC bus and the transformer core cross-section area A_{Fe}(10) are constant, the information of the core quality is given by the operating frequency f of the system itself and, such that a lower frequency of the system means a higher iron core quality.

## Patentansprüche

1. Vorrichtung zur Bestimmung der Qualität eines magnetischen Kreises (1), wobei die Vorrichtung Pulsanregung und einen Zweipunktregler (Hysterese-Regler) (4) zum Steuern des Stroms in der Primärwicklung (2) eines Transformators umfasst, wobei die Vorrichtung so konfiguriert ist, dass der Zweipunktregler (4) eine Quellenspannung umschaltet, wenn der Strom in der Primärwicklung (2) einen gewählten Maximalwert *I*ₘₐₓ erreicht, und **dadurch gekennzeichnet ist, dass** die Vorrichtung derart konfiguriert ist, um magnetische Eigenschaften des Magnetkreises auf der Grundlage einer Betriebsfrequenz des Systems, eines Kernquerschnitt *A*_{Fe} (10) des Eisenkerns und einer berechneten Blindleistung zu bewerten.

2. Vorrichtung nach dem vorhergehenden Anspruch, die **dadurch gekennzeichnet ist, dass** sie einen Primärstromsensor (3), eine Steuerungslogik zur Schaltung eines Wechselrichters (5), einen Wechselrichter (6), einen Gleichstromzwischenkreis und einen primären Spannungssensor (8) umfasst.

3. Verfahren zum Testen eines Magnetkreises, wobei das Verfahren einen Schritt zur Bestimmung der Qualität des Magnetkreises durch Verwendung der Vorrichtung nach einem der vorhergehenden Ansprüchen umfasst und **dadurch gekennzeichnet** ist, das der Schritt zur Bestimmung der Qualität die Auswertung der Qualität des Magnetkreises umfasst, wobei ein niedriger Produkt der Kernquerschnittsfläche A_{Fe} und der Frequenz *f*, A_{Fe}**f*, und eine niedrigere Blindleistung *Q* auf bessere Kernqualität hinweisen.

4. Verfahren nach Anspruch 3, das **dadurch gekennzeichnet ist, dass** die Messung eine oder mehrere Perioden dauert.

5. Verfahren nach einem der Ansprüche 3 oder 4, das **dadurch gekennzeichnet ist, dass** die Eigenschaften einer Luftspaltfläche (10) eines Transformatoreisenkerns und anderen Eigenschaften, wie beispielsweise Eigenschaften von Kernschäden, bestimmt werden.

6. Verfahren nach einem der Ansprüche 3 bis 5, das **dadurch gekennzeichnet ist, dass** in dem Fall, wenn die Zwischenkreisspannung und die Transformatorkern Querschnittsfläche *A*_{Fe} (10) konstant sind, die information über die Kernqualität durch die Betriebsfrequenz *f* des Systems selbst gegebenen ist, derart dass eine niedrigere Betriebsfrequenz des Systems auf eine höhere Kernqualität hinweist.

## Revendications

1. Un appareil pour la détermination de la qualité d'un circuit magnétique (1), cet appareil comprenant un dispositif pour l'excitation de l'impulsion et un régulateur d'hystérésis (4) assurant la régulation d'un courant dans l'enroulement primaire d'un transformateur (2), cet appareil étant configuré de sorte que ledit régulateur d'hystérésis (4) assure la commutation d'une tension source lorsque l'intensité dans l'enroulement primaire (2) atteint une valeur maximum Iₘₐₓ, **caractérisé par le fait que** cet appareil est configuré pour évaluer une caractéristique magnétique du circuit magnétique sur la base d'une fréquence d'utilisation du système, d'une section transversale de noyau A_{Fe} (10) d'un noyau de fer, et d'une puissance réactive calculée.

2. Un appareil selon la revendication précédente, **caractérisé par le fait qu'**il comprend un capteur de courant primaire (3), une logique de commande pour la commutation d'un convertisseur (5), un convertisseur (6), un bus c.c., et un capteur de tension primaire (8).

3. Une méthode d'essai d'un circuit magnétique, cette méthode comprenant un stade de détermination de la qualité du circuit magnétique par l'emploi de l'appareil selon une quelconque des revendications précédentes, **caractérisée par le fait que** le stade de la détermination de la qualité comprend l'estimation de la qualité du circuit magnétique, un tel produit décroissant de la section transversale de noyau A_{Fe} avec une fréquence f, A_{Fe}*f, et une puissance réactive inférieure Q, déterminent une meilleure qualité du noyau.

4. Une méthode selon la revendication 3, **caractérisée par le fait que** la mesure dure une ou plusieurs périodes.

5. Une méthode selon une quelconque des revendications 3 ou 4, **caractérisée par le fait que** sont déterminées les propriétés d'une surface d'entrefer (10) d'un noyau de fer de transformateur, ainsi que d'autres propriétés, par exemple celles d'endommagements du noyau.

6. Une méthode selon une quelconque des revendications 3 à 5, **caractérisée par le fait que** dans l'éventualité où la tension du bus c.c. et la section transversale de noyau A_{Fe} (10) du transformateur soient constantes, les informations sur la qualité du noyau sont fournies par la fréquence de service f du système lui-même, et qu'une fréquence inférieure du système signifie une qualité supérieure du noyau de fer.
